Europäisches Patentamt

(19) European Patent Office    (11) Numéro de publication: **0 041 890**
Office européen des brevets    **B1**

(12) **FASCICULE DE BREVET EUROPEEN**

(45) Date de publication du fascicule du brevet:    (51) Int. Cl.⁴: **H 01 L 29/78**, G 02 F 1/133
27.11.85

(21) Numéro de dépôt: 81400879.3

(22) Date de dépôt: 02.06.81

(54) Elément à conduction non linéaire, et dispositif à commutation, de visualisation notamment, incorporant un tel élément.

(30) Priorité: 06.06.80 FR 8012596

(43) Date de publication de la demande:
16.12.81 Bulletin 81/50

(45) Mention de la délivrance du brevet:
27.11.85 Bulletin 85/48

(84) Etats contractants désignés:
**DE GB NL**

(56) Documents cités:
**FR - A - 1 425 906**
**US - A - 4 065 781**

**PROCEEDINGS OF THE IEEE, vol. 55, juillet 1967, NEW YORK (US), R.G. WAGNER et al.: "A dual offset gate thin-film transistor", pages 1217-1218**
**ELECTRONIQUE ET APPLICATIONS INDUSTRIELLES, no. 251, 1er juin 1978, PARIS (FR), F. MORIN: "Des transistors en couches minces pour les écrans de visualisation", pages 15-16**
**IEEE TRANSACTIONS ON ELECTRON DEVICES, vol. ED-22, no. 9, septembre 1975, NEW YORK (US), G. KRAMER: "Thin-film-transistor switching matrix for flat-panel display", pages 733-739**
**THIN SOLID FILMS, vol. 67, avril 1980, LAUSANNE (CH), B.D. CHASE et al.: "Materials analysis of thin film transistors", pages 207-228**

(73) Titulaire: **THOMSON-CSF, 173, Boulevard Haussmann, F-75379 Paris Cedex 08 (FR)**

(72) Inventeur: **Fraleux, Jean, THOMSON-CSF SCPI 173, bld Haussmann, F-75360 Paris Cedex 08 (FR)**
Inventeur: **Ploix, Jean-Luc, THOMSON-CSF SCPI 173, bld Haussmann, F-75360 Paris Cedex 08 (FR)**

(74) Mandataire: **Mayeux, Michèle et al, THOMSON-CSF SCPI 173, Bld Haussmann, F-75379 Paris Cedex 08 (FR)**

Il est rappelé que: Dans un délai de neuf mois à compter de la date de publication de la mention de la délivrance du brevet européen toute personne peut faire opposition au brevet européen délivré, auprès de l'Office européen des brevets. L'opposition doit être formée par écrit et motivée. Elle n'est réputée formée qu'après paiement de la taxe d'opposition (Art. 99(1) Convention sur le brevet européen).

## Description

La présente invention concerne un élément à conduction non linéaire.

Elle concerne également les dispositifs à commutation, notamment de visualisation, incorporant un tel élément.

De tels dispositifs peuvent concerner par exemple l'adressage de panneaux d'affichage ou la lecture de panneaux de détection de grande dimension. De tels panneaux, dont le fonctionnement est connu de l'homme de l'art, sont réalisés à l'aide de deux dalles de verre planes parallèles fixées l'une à l'autre de façon à ménager entre elles un espace qui est rempli de cristal liquide par exemple. Les éléments de commutation utilisés dans de tels dispositifs sont habituellement des transistors à effet de champ réalisés en couche minces.

Les connexions de ces transistors aux dalles de verre ne sont pas sans problème par suite de l'existence d'un réseau d'électrodes croisées sur l'une des faces.

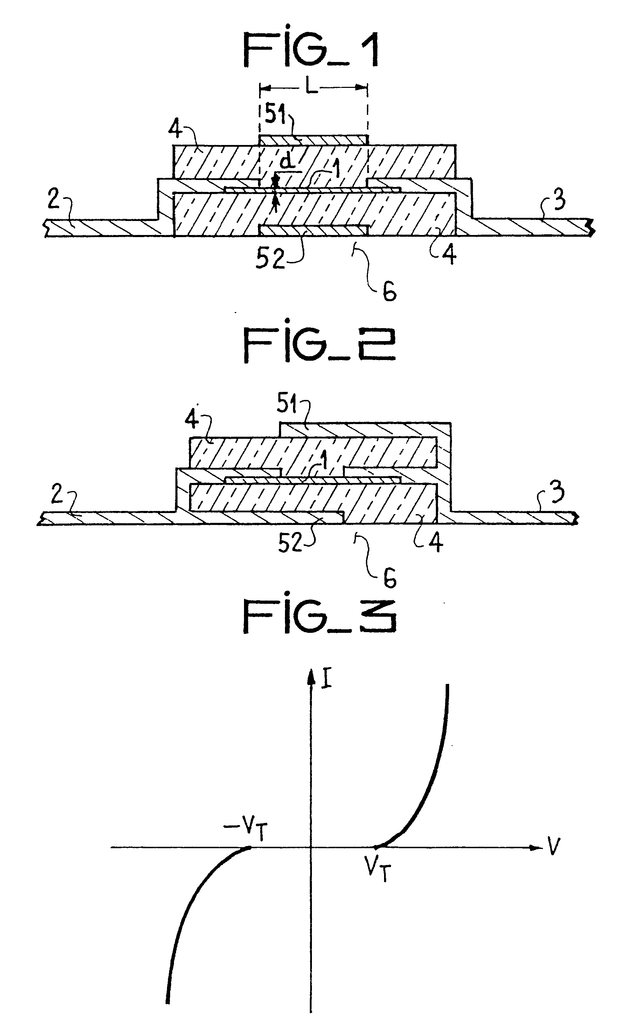

On connaît par l'article de F. Morin paru dans «Electronique et Applications industrielles», numéro 251, du 1er juin 1978, et par l'article de G. Kramer paru dans IEEE transactions on electron devices, volume ED-22, no. 9, septembre 1975 des transistors à effet de champ en couches minces comportant des électrodes de drain et de source et une grille double, en deux parties, comme cela sera illustré par la figure 1 de la présente demande.

La présente invention se propose de supprimer cet inconvénient en remplaçant les transistors à effet de champ en couche mince par des composants du même type mais ne comportant que deux électrodes électriquement indépendantes au lieu de trois. Les problèmes de connexions des électrodes aux dalles de verre s'en trouvent de ce fait diminués.

L'élément à conduction non linéaire selon l'invention est constitué d'un corps semiconducteur en couche mince pris entre deux couches isolantes, de deux électrodes de source et de drain en contact de chaque côté avec le corps semiconducteur et d'une électrode de grille double consistant en une première partie conductrice appliquée sur l'une des couches isolantes, sur sa face opposée à celle en contact avec le corps semiconducteur, et en une seconde partie conductrice appliquée sur l'autre couche isolante dite seconde couche, sur sa face opposée à celle en contact avec le corps semiconducteur, l'ensemble ainsi constitué étant posé sur un substrat isolant sur lequel il repose par l'électrode de grille.

L'élément selon l'invention se distingue du transistor à effet de champ connu dans l'art antérieur par le fait qu'il ne comporte que deux électrodes électriquement indépendantes, la source et le drain, la troisième électrode, la grille, étant séparée en deux parties respectivement reliées électriquement à la source et au drain.

L'invention sera mieux comprise en se reportant à la description suivante, donnée à titre d'exemple non limitatif et illustrée par les figures annexées qui représentent:

   – la fig. 1, un schéma en coupe d'un transistor à effet de champ de l'art antérieur;

   – la fig. 2, un schéma en coupe d'un élément selon l'invention;

   – la fig. 3, la caractéristique I [V] de l'élément selon l'invention;

   – la fig. 4a, un diagramme schématique d'un panneau d'affichage matriciel à cristaux liquides utilisant des composants selon l'invention;

   – la fig. 4b, un exemple de réalisation d'un panneau d'affichage matriciel à cristaux liquides utilisant des composants selon l'invention.

La figure 1 représente un schéma en coupe d'un transistor à effet de champ classique connu de l'art antérieur.

Un tel transistor comporte sur un substrat isolant 6 une couche semiconductrice 1 comprise entre deux électrodes: la source 2 et le drain 3. La troisième électrode, la grille, est isolée de la couche semiconductrice par une couche diélectrique 4. Cette grille est située soit au-dessous, soit au-dessus du semiconducteur soit encore partagée en deux parties situées respectivement au-dessus 51 et au-dessous 52, du semiconducteur, comme c'est le cas de la figure 1, ces deux parties étant électriquement reliées.

Le fonctionnement d'un tel transistor s'explique brièvement comme suit.

Soient L, 1, d la longueur, la largeur et l'épaisseur du canal semiconducteur. La largeur 1, non représentée sur la figure, se mesure dans une direction perpendiculaire au plan de la figure.

Soient $G_1$, $G_2$ respectivement les grilles inférieure et supérieure.

Soient $V_{G1}$, $V_{G2}$, $V_D$ les tensions appliquées respectivement à $G_1$, $G_2$ et au drain relativement à la source.

Soit V(x) le potentiel existant au point d'abscisse x du canal semiconducteur.

Si $n_o$ est la densité de porteurs de charges à l'équilibre dans le semiconducteur et $C_i$ la capacité par unité de surface de l'une des couches isolantes, la densité de porteurs de charge au point d'abscisse x du semiconducteur est dans le cas d'un canal à conduction par électron:

$$n(x) = n_o + \Delta n(x)$$

$$\text{avec } \Delta n(x) = -\frac{Ci}{dq}[2V(x) - (V_{G1} + V_{G2})]$$

On définit la tension de seuil par

$$V_T = -\frac{qdn_o}{c_i}$$

On obtient donc:

$$n(x) = \frac{C_i}{qd}[(V_{G1} + V_{G2} - V_T - 2V(x)]$$

La conductivité au point d'abscisse x est donc:

$$\tau(x) = \frac{\mu C_i}{d} [(V_{G1} + V_{G2} - V_T) - 2V(x)]$$

où $\mu$ est la mobilité des porteurs de charge. Le courant I traversant le transistor est donc:

$$I = 1d\,\tau(x)\ \frac{dV}{dx}$$

soit:

$$I = 1\mu C_i [(V_{G1} + V_{G2} - V_T) - 2V(x)]\ \frac{dV(x)}{dx}$$

L'intégration de cette expression entre x = o et x = L donne:

$$I = \frac{1}{L}\ \mu C_i [(V_{G1} + V_{G2} - V_T) V_D - V_D^2]$$

Cette relation traduit le fonctionnement du transistor en régime non saturé. Lorsque:

$$V_D > \frac{V_{G1} + V_{G2} - V_T}{2}$$

le transistor devient saturé. Le courant devient:

$$I_{sat} = \frac{1}{L}\mu C_i\ \frac{(V_{G1} + V_{G2} - V_T)^2}{4}$$

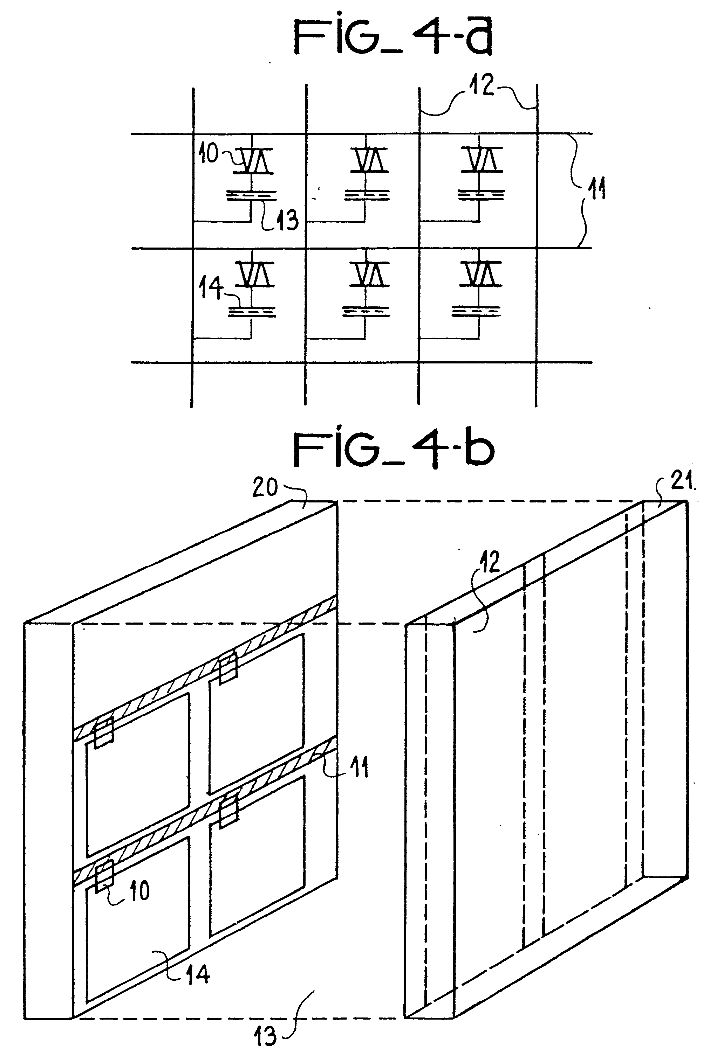

La figure 2 représente le schéma en coupe d'un élément selon l'invention.

L'invention consiste à modifier la structure du transistor couche mince à double grille décrit dans la figure 1. Les deux grilles ne sont plus électriquement reliées entre elles, mais respectivement reliées l'une à la source et l'autre au drain. La grille supérieure 51 est ainsi au même potentiel que la source 2.

L'élément selon l'invention est donc constitué d'un corps semiconducteur 1 inséré entre deux couches isolantes 4, de deux électrodes de source et de drain 2 et 3 et d'une électrode de grille double composée d'une partie 52 reliée électriquement à la source 2 et d'une partie 51 reliée électriquement au drain 3.

Le corps semiconducteur 1 est constitué d'un des matériaux suivants: séléniure de cadmium Cd Se, sélénium Se, telure Te, sulfure de plomb Pb S, silicium Si ou silicium amorphe hydrogéné.

Les couches isolantes 4 ont une épaisseur comprise entre 50 nm et 500 nm.

Les électrodes de source et de drain 2 et 3 sont réalisées avec des matériaux assurant un bon contact ohmique avec la couche semiconductrice 1. Ces matériaux sont choisis dans le groupe des métaux suivants molybdène Mo, chrome Cr, or Au, indium In, cuivre Cu, argent Ag, cadmium Cd, ou un alliage de ces métaux.

Les conditions de fonctionnement de l'élément selon l'invention se traduisent par l'equation:

$$V_{G1} = o$$
$$V_{G2} = V_D$$

Si l'on porte ces conditions dans les expressions du courant en régime normal et saturé calculées précédemment dans le cas du transistor à effet de champ de l'art antérieur décrit dans la figure 1, on en déduit les expressions du courant en régime normal et saturé dans le cas de l'élément selon l'invention.

En régime normal I = $\dfrac{1}{L}\ \mu C_i(-V_T V_D)$

En régime saturé I = $\dfrac{1}{L}\ \mu C_i\ \dfrac{(V_D - V_T)^4}{4}$

Le cas particulièrement intéressant pour le composant selon l'invention est le cas où $V_T$ est positif. Le régime non saturé est alors physiquement impossible car il correspondrait à une caractéristique à résistance négative.

La caractéristique I (V) de l'élément selon l'invention est représentée sur la figure 3.

La partie négative de cette caractéristique se déduit de la partie positive en raison de la symétrie de construction du composant de l'invention.

La caractéristique fortement non linéaire de ce composant permet de l'utiliser comme élément de commutation. En particulier, à titre d'exemple non limitatif, il peut être utilisé dans un panneau d'affichage matriciel.

Les figures 4a et 4b donnent un exemple de cette application.

La figure 4a représente un diagramme schématique d'un panneau d'affichage matriciel à cristaux liquides utilisant des composants selon l'invention.

La figure 4b illustre un exemple de réalisation d'un tel panneau d'affichage matriciel à cristaux liquides utilisant des composants selon l'invention.

Un tel panneau d'affichage matriciel à cristaux liquides est constitué, comme représenté sur la figure 4a, d'un certain nombre d'électrodes de ligne 11, d'un certain nombre d'électrodes de colonne 12, d'éléments de cristaux liquides 13 dont les électrodes de commande 14 sont en série avec les éléments de commutation à savoir les éléments bipolaires selon l'invention 10.

Un exemple de réalisation d'un tel panneau d'affichage et son mode de fonctionnement sont illustrés par la figure 4b.

Un tel panneau est réalisé à l'aide de deux dalles planes parallèles fixées l'une à l'autre de façon à ménager entre elles en espace qui est rempli de cristal liquide.

Une première dalle 20 porte les électrodes de ligne 11, les composants selon l'invention 10 et les électrodes de commande 14 du cristal liquide représenté dans son exemple par le même repère 13.

Une deuxième dalle 21 porte les électrodes transparentes de colonne 12.

Selon l'effet électrooptique du cristal liquide utilisé, sont ajoutés des éléments nécessaires connus de l'homme de l'art non représentés sur la figure: couche d'alignement du cristal liquide sur les parois, polariseurs de la lumière.

Le fonctionnement d'un tel dispositif matriciel possédant à chaque intersection de ligne et de colonne un élément non linéaire est connu de l'homme de l'art.

A titre d'exemple non limitatif, un mode de fonctionnement est décrit ci-dessous dans le cas où l'information à afficher est binaire.

Le mode d'adressage retenu est un adressage ligne par ligne.

Chacune des lignes est portée à tour de rôle à un potentiel $V_1$, tandis que toutes les autres sont maintenues à un potentiel nul. Simultanément, les colonnes sont portées soit à un potentiel

$$\frac{V1}{2} \text{, soit à un potentiel} \frac{-V_1}{2}.$$

Les différences de potentiel entre lignes et colonnes que l'on peut observer sur la matrice sont alors:

$$V_L = O \qquad V_C = \frac{V_1}{2} \qquad V_L - V_C = -\frac{V_1}{2}$$

$$V_L = O \qquad V_C = -\frac{V_1}{2} \qquad V_L - V_C = \frac{V_1}{2}$$

$$V_L = V_1 \qquad V_C = \frac{V_1}{2} \qquad V_L - V_C = \frac{V_1}{2}$$

$$V_L = V_1 \qquad V_C = -\frac{V_1}{2} \qquad V_L - V_C = \frac{3V_1}{2}$$

Si l'on prend $V_1 = V_T$ et si l'on se reporte à la figure 3 représentant la caractéristique I (V) du transistor à effet de champ selon l'invention, on constate qu'aucun courant ne peut circuler dans les trois premiers cas, au contraire de ce qui se passe dans le quatrième. Si la situation ainsi décrite dure un temps suffisant, la capacité formée par le cristal liquide lui-même se charge sous une tension $V_T/2$ qui doit être calculée suffisante pour que le cristal liquide soit excité.

Une possibilité offerte par ce dispositif est de renverser toutes les polarités à chaque trame, en raison de la symétrie des caractéristiques électriques des composants.

Dans un tel mode de fonctionnement, le cristal liquide est excité en tension alternative, ce qui améliore considérablement sa durée de vie.

## Revendications

1. Elément à conduction non linéaire constitué d'un corps semiconducteur (1) en couche mince pris entre deux couches isolantes (4), de deux électrodes de source (2) et de drain (3) en contact de chaque côté avec le corps semiconducteur, et, d'une électrode de grille double (51, 52), cette électrode de grille consistant en une première partie conductrice (51) appliquée sur l'une des couches isolantes, sur sa face opposée à celle en contact avec le corps semiconducteur, et en une seconde partie conductrice (52) appliquée sur l'autre couche isolante, dite seconde couche, sur sa face opposée à celle en contact avec le corps semiconducteur, l'ensemble ainsi constitué étant posé sur un substrat isolant (6) sur lequel il repose par l'électrode de grille, caractérisé en ce que les deux parties de l'électrode de grille (51, 52) sont respectivement reliées électriquement aux électrodes de source (2) et de drain (3).

2. Elément selon la revendication 1, caractérisé en ce que l'épaisseur desdites couches isolantes (4) est comprise entre 50 nm et 500 nm.

3. Elément selon la revendication 1, caractérisé en ce que l'électrode de source (2) est en molybdène.

4. Elément selon la revendication 1, caractérisé en ce que l'électrode de source (2) est en chrome.

5. Elément selon la revendication 1, caractérisé en ce que l'électrode de drain (3) est en molybdène.

6. Elément selon la revendication 1, caractérisé en ce que l'électrode de drain (3) est en chrome.

7. Panneau d'affichage matriciel à cristaux liquides constitué de deux dalles planes parallèles (20, 21) entre lesquelles est insérée une lame de cristal liquide (13), d'une série d'électrodes de ligne (11) fixées à l'une des dalles, d'une série d'électrodes de colonne (12) fixées à l'autre dalle et orientées perpendiculairement aux électrodes de ligne, les points de croisement de deux électrodes de séries différentes définissant les cellules du cristal liquide aux bornes desquelles sont appliquées, en fonctionnement, des différences de potentiel, par l'intermédiaire d'éléments de commutation (10), caractérisé en ce que ces éléments de commutation sont des éléments à conduction non linéaire suivant l'une des revendications 1 à 6.

## Patentansprüche

1. Nichtlineares Widerstandselement bestehend aus einem Dünnschicht-Halbleiterkörper (1), der zwischen zwei isolierenden Schichten (4) liegt, aus zwei Elektroden, nämlich einer Source (2) und einem Drain (3), die auf jeder Seite in Berührung mit dem Halbleiterkörper stehen, und aus einer doppelten Gitterelektrode (51, 52), die aus einem ersten leitenden Teil (51), der auf einer der isolierenden Schichten auf der Seite aufliegt, die nicht mit dem Halbleiterkörper in Berührung steht, und aus einem zweiten leitenden Teil (52) besteht, der auf der anderen isolierenden Schicht, zweite Schicht genannt, und zwar auf deren nicht mit dem Halbleiter in Berührung stehenden Oberfläche, aufliegt, wobei das so gebildete Ganze auf einem isolierenden Träger (6) unter Einfügung der Gitterelektrode aufliegt, dadurch gekennzeichnet, dass die beiden Teile der Gitterelektrode (51, 52) elektrisch mit der Source-Elektrode (2) bzw. der Drain-Elektrode (3) verbunden sind.

2. Element nach Anspruch 1, dadurch gekennzeichnet, dass die Dicke der isolierenden Schichten (4) zwischen 50 und 500 nm liegt.

3. Element nach Anspruch 1, dadurch gekennzeichnet, dass die Source-Elektrode (2) aus Molybdän ist.

4. Element nach Anspruch 1, dadurch gekennzeichnet, dass die Source-Elektrode (2) aus Chrom ist.

5. Element nach Anspruch 1, dadurch gekennzeichnet, dass die Drain-Elektrode (3) aus Molybdän ist.

6. Element nach Anspruch 1, dadurch gekennzeichnet, dass die Drain-Elektrode (3) aus Chrom ist.

7. Matrixartige Flüssigkristall-Anzeigetafel bestehend aus zwei ebenen zueinander parallelen Platten (20, 21), zwischen denen ein Flüssigkristallplättchen (13) eingefügt ist, aus einer Serie von Zeilenelektroden (11), die auf einer der Platten befestigt sind, aus einer Serie von Spaltenelektroden (12), die an der anderen Platte befestigt sind und senkrecht zu den Zeilenelektroden verlaufen, wobei die Kreuzungspunkte von zwei Elektroden der beiden Serien Flüssigkristallzellen definieren, an deren Klemmen in Betrieb Potentialdifferenzen über Schaltelemente (10) angelegt werden, dadurch gekennzeichnet, dass diese Schaltelemente nichtlineare Widerstandselemente nach einem der Ansprüche 1 bis 6 sind.

**Claims**

1. An element having a non linear conductivity characteristic, constituted by a thin layer semiconductor body (1) interposed between two insulating layers (4), by a source electrode (2) and a drain electrode (3), each one connected to one side of the semiconductor body, and by a twin gate electrode (51, 52), this gate electrode consisting of a first conductive part (51) applied onto one of the insulating layers on the surface thereof which is opposed to the surface connected to the semiconductor body, and of a second conductive part (52) applied onto the other insulating layer, called second layer, on the surface thereof which is opposed to the surface connected to the semiconductor body, the assembly thus constituted being supported by an insulating substrate (6) with the interposition of the gate electrode, characterized in that the two parts of the gate electrode (51, 52) are connected to the source electrode (2) and the drain electrode (3) respectively.

2. An element according to claim 1, characterized in that the thickness of said insulating layers (4) is chosen between 50 nm and 500 nm.

3. An element according to claim 1, characterized in that the source electrode (2) is made of molybdenum.

4. An element according to claim 1, characterized in that the source electrode (2) is made of chrome.

5. An element according to claim 1, characterized in that the drain electrode (3) is made of molybdenum.

6. An element according to claim 1, characterized in that the drain electrode (3) is made of chrome.

7. A matrix type liquid cristal display panel constituted by two planar parallel plates (20, 21) with a liquid cristal layer (13) inserted therebetween, by a group of line electrodes (11) affixed to one of the plates, by a group of column electrodes (12) affixed to the other plate and disposed perpendicularly to said line electrodes, the points of intersection of the respective electrodes of different groups defining the liquid cristal cells, the terminals of which are supplied during operation with differential potentials through commuting components (10), characterized in that these commuting components are elements of nonlinear conductivity according to one of claims 1 to 6.

# FIG_1

L

51

4

d

1

2

3

52

4

6

# FIG_2

51

4

1

2

3

52

4

6

# FIG_3

I

−V_T

V_T

V

# FÍG_4·a

# FÍG_4·b